(19) Europäisches Patentamt
European Patent Office
Office européen des brevets

(11) **EP 3 123 471 B1**

(12) **EUROPÄISCHE PATENTSCHRIFT**

(45) Veröffentlichungstag und Bekanntmachung des Hinweises auf die Patenterteilung:
**18.04.2018 Patentblatt 2018/16**

(21) Anmeldenummer: **15712869.5**

(22) Anmeldetag: **24.03.2015**

(51) Int Cl.:
*G11B 20/10* (2006.01)      *H03G 5/02* (2006.01)
*H03G 5/16* (2006.01)

(86) Internationale Anmeldenummer:
**PCT/EP2015/056254**

(87) Internationale Veröffentlichungsnummer:
**WO 2015/144703 (01.10.2015 Gazette 2015/39)**

(54) **ENTZERRER, AUDIOANLAGE MIT EINEM SOLCHEN ENTZERRER UND VERFAHREN ZUR ENTZERRUNG EINES TONGEMISCHS**

EQUALISER, AUDIO SYSTEM WITH SUCH AN EQUALISER AND METHOD FOR EQUALISING A SOUND MIX

CORRECTEUR DE TONALITÉ, INSTALLATION AUDIO AVEC UN TEL CORRECTEUR DE TONALITÉ ET PROCÉDÉ DE CORRECTION D'UN SON COMPLEXE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.03.2014 DE 202014101373 U**

(43) Veröffentlichungstag der Anmeldung:
**01.02.2017 Patentblatt 2017/05**

(73) Patentinhaber: **Schwede, Bernhard**
**80995 München (DE)**

(72) Erfinder: **Schwede, Bernhard**
**80995 München (DE)**

(56) Entgegenhaltungen:
**JP-A- H01 248 798        US-A1- 2003 035 555
US-A1- 2012 183 150      US-B1- 7 058 126**

**Beschreibung**

Die vorliegende Erfindung betrifft einen Entzerrer, eine Audioanlage mit einem solchen Entzerrer und ein Verfahren zur Entzerrung eines Tongemischs.

Die vorliegende Erfindung betrifft insbesondere einen Entzerrer / eine Audioanlage / ein Verfahren zur gehörlinearisierenden Entzerrung eines Tongemischs.

Der Mensch nimmt akustische Reize oder Schall durch sein Gehör oder Gehörsystem wahr. Zum Gehör gehört unter anderem das äußere Ohr, das Mittelohr mit den Gehörknöchelchen und das Innenohr mit der Schnecke und den damit verbundenen Nerven sowie die im Großhirn und im Stammhirn liegenden auditiven Reizverarbeitungszentren. Aufgrund dieser komplexen Anatomie und der bis heute noch nicht bis ins Detail erklärbaren Physiologie und Funktionsweise ist die Wahrnehmung akustischer Reize nicht linear, d. h. nicht gleich intensiv für alle Wellenlängen. Vielmehr gibt es eine spektrale (frequenzabhängige) Hörempfindlichkeit, die zudem lautstärkeabhängig ist.

Insbesondere die Lautstärkeabhängigkeit führt zum Beispiel dazu, dass sich ein von einem Tonträger in einem im Vergleich zu einem Konzertsaal kleinen Zimmer abgespieltes Musikstück gegenüber dem Live-Erlebnis unnatürlich anhört. Es ist bekannt, diese Unnatürlichkeit dadurch zu beseitigen, dass die Lautstärke spiegelbildlich zur Hörempfindlichkeit korrigiert wird, was in so genannten "Kurven gleicher Lautstärkepegel" dargestellt wird. Es hat sich jedoch gezeigt, dass die hierbei angewendeten Korrekturkurven die gewünschte klangliche Natürlichkeit nur bedingt rekonstruieren, da zu ihrer Ermittlung den Testpersonen einzelne Sinustöne vorgespielt werden, die Lautstärkewahrnehmung jeder einzelnen Frequenz jedoch von der Lautstärke zeitgleich wahrgenommener weiterer Frequenzen beeinflusst wird. Insbesondere ist die Musik zu basslastig, wodurch Rauminformationen, Transienten, Einschwingvorgänge, Timbres von Musikinstrumenten, Hallfahnen usw. durch so genannte Verdeckungseffekte weniger hörbar sind, was die Aufnahme unpräzise und schwammig erscheinen lässt. Dieser Effekt wird noch durch eine Überbetonung der Mitten verstärkt, da dadurch das klanglich sehr sensible Gleichgewicht von Grund- und Obertönen bei Musikinstrumenten, das ja gerade den besonderen Wohlklang und die Besonderheit eines Instruments ausmacht, verschoben wird.

Es ist Aufgabe der vorliegenden Erfindung, einen Entzerrer bereitzustellen, der durch einen optimalen Ausgleich aller Nichtlinearitäten des Gehörs bei jeder Lautstärke eine größtmögliche Natürlichkeit eines Tongemischs, insbesondere von Musik, erzeugt.

Diese Aufgabe wird durch die Merkmale der Ansprüche 1, 10 bzw. 11 gelöst.

Weitere vorteilhafte Weiterbildungen sind in den Unteransprüchen definiert.

Ein Entzerrer gemäß der vorliegenden Erfindung (Anspruch 1) entzerrt ein Tongemisch aus Tönen unterschiedlicher Frequenzen (f) gemäß einer Entzerrungskurve (P(f)), die eine frequenzabhängige Änderung von Schallpegeln (P) der Töne zeigt und bei Frequenzen

$$f^E_{(n)} = k^n \cdot f_0$$

Extrema $(P(n) \equiv R(f_{(n)}))$ und bei Frequenzen

$$f^N_{(n)} = k^{(n-1/2)} \cdot f_0$$

Nullpunkte $(N(n) \equiv N(f_{(n)}))$ besitzt, wobei $n \in$ , $f_0$ eine Frequenz eines vorbestimmten Extremums $(P(0))$ und $1{,}5^2 \leq k \leq 1{,}8^2$ ist, gehörlinearisierend.

Eine "Entzerrung" ist gemäß der vorliegenden Erfindung eine frequenzabhängig "Änderung von Schallpegeln (P)" (in Dezibel (dB)), wobei die Gesamtheit aller gleichzeitig wahrgenommenen Töne mit ihren jeweiligen Schallpegeln als "Lautheit" bezeichnet wird und eine durch Normen festgelegte Größe zur proportionalen Abbildung des menschlichen Lautstärkeempfindens ist. Die Einheit der Lautheit ist das Sone, das wiederum auf der Definition des Lautstärkepegels (oder einfach der 'Lautstärke') in Phon beruht.

Insbesondere wird einer Lautstärke von 40 phon die Lautheit 1 sone zugeordnet, wobei eine Lautstärke von 40 phon durch die Lautstärke eines Sinustons mit der Frequenz 1 kHz und einem Schalldruckpegel von 40 dB definiert ist.

Die Entzerrungskurve ist vorzugsweise eine stetige, differenzierbare Funktion der Frequenz f. Die erfindungsgemäße Entzerrung basiert auf der Erkenntnis, dass 'messtechnisch linear' nicht gleichbedeutend mit 'gehörmäßig linear' ist, weil hier auf das menschliche Gehör Bezug genommen ist, das auf verschiedene Frequenzen bei verschiedenen Lautstärken unterschiedlich reagiert. Diese Tatsache wurde bereits 1933 von Fletcher und Munson untersucht und führte zu den 'psychoakustischen Kurven gleicher Lautstärke', die in ISO-Standard 226: 2003 - die im Jahre 2003 korrigierte Fassung der ISO-Recommendation 226 - und DIN 45630 Bl. 2 (DIN 1318) festgelegt sind. Mit einer gemäß diesen Kurven durchgeführten Entzerrung eines Tongemisches wird erreicht, dass Schallaufnahmen so wiedergegeben werden, dass sie bei unterschiedlichen Lautstärken einen ähnlichen Höreindruck ergeben. Diese Form der an das menschliche Gehör angepassten Entzerrung wird "gehörlinearisierend" genannt. Eine gehörlinearisierende korrigierte Schallaufnahme wird als 'natürlich' empfunden.

Gemäß der vorliegenden Erfindung wird der Entzerrer, wie oben bereits angedeutet, nicht auf reine Sinustöne (Messtöne), sondern auf ein "Tongemisch" angewendet, das Töne unterschiedlicher Frequenzen und unterschiedlicher Musikinstrumente umfasst. Insbesondere ist ein Tongemisch gemäß DIN 1320 ein Schall, der sich aus Tönen beliebiger Frequenzen zusammensetzt und auch 'Rauschen' oder 'Geräusche' als nicht periodische Sonderformen enthält. Darüber hinaus wird durch den erfindungsgemäßen Entzerrer die Veränderung eines aufgezeichneten Tongemisches durch die Umgebung seiner Wiedergabe berücksichtigt.

Da der erfindungsgemäße Entzerrer einem Schallwandler einer Audioanlage vorgeschaltet ist (vgl. Anspruch 10), die erfindungsgemäße Entzerrung also auf das von der Audioanlage erzeugte Tongemisch angewendet wird, betrifft sie alle Töne einschließlich der Obertöne und somit die Klangfarbe, die durch die erfindungsgemäße Entzerrung ihre 'Natürlichkeit' wieder erhält.

Da Menschen unter Umständen unterschiedliche Aussagen bezüglich des Tongemischs / Klangs treffen, den sie als 'natürlich' wahrnehmen, der Begriff der ‚Natürlichkeit' also subjektiv ist, wurden vom Erfinder der vorliegenden Erfindung zahlreiche Experimente durchgeführt.

Insbesondere wurde ein digitaler 31 Band Graphic Equalizer verwendet, der keine Zeit- oder Phasenverschiebungen erzeugt und eine Anhebung oder Absenkung genormter Frequenzbereiche in 0,5 dB Schritten erlaubt. Die experimentell ermittelten Kurven konnten abgespeichert und ihre Wirkung auf das Tongemisch untereinander und mit linearen Wiedergaben verglichen werden. Zahlreiche Variationen einer möglichen Korrekturkurve wurden systematisch angelegten Hörtests unterzogen, wobei auf Musikstücke, Filme, Instrumental- und Vokalaufnahmen und sogar Live-Veranstaltungen zurückgegriffen wurde. Bei allen Studioexperimenten wurden Nahfeldmonitore verwendet, wobei als Parameter die Lautstärke variiert und mittels eines Schallpegelmessgeräts kontrolliert wurde.

Erfindungsgemäß weist die Entzerrungskurve Extrema und Nullpunkte auf, die von k abhängen, wobei $1,5^2 \le k \le 1,8^2$ gilt. Vorzugsweise nimmt k den Wert 1,618 an. Es ist zu beachten, dass die Zahl 1,618 eine Näherung der irrationalen Goldenen Zahl ist, die den Goldenen Schnitt beschreibt: Wird zum Beispiel eine Strecke der Länge s nach dem Goldenen Schnitt in einen größeren Abschnitt g und einen kleineren Abschnitt k unterteilt, so ist s/g = g/k = 1,618 = die Goldene Zahl. Um vom Beispiel der Länge zur vorliegenden Erfindung zu gelangen, ist lediglich die (im Beispiel beliebig gewählte) Einheit der Länge gegen die Frequenz auszutauschen.

Die Zahl 1,618 ergibt sich auch als Grenzwert

$$\lim_{n\to\infty} \frac{f_{n+1}}{f_n}$$ der rekursiv definierten Fibonacci-Folge, wobei jedes Element $f_n$ einer Folge von natürlichen Zahlen gemäß der Vorschrift $f_{n-2} = f_n - f_{n-1}$ aus den zwei vorherigen Elementen der Folge definiert ist und $f_0 = 0$ und $f_1 = 1$ als Ausgangspunkt festgelegt ist.

Aus der Definition der Lage der Extrema und Nullpunkte ist ersichtlich, dass die Entzerrungskurve zwar eine oszillierende, jedoch keine periodische Funktion der Frequenz f ist.

Gemäß einer vorteilhaften Weiterbildung (Anspruch 2) gilt für alle n gilt: $|P(n)| > |P(n+1)|$.

Das heißt, die (betragsmäßige) Amplituden der Entzerrungskurve nehmen mit zunehmender Frequenz ab. Diese prinzipielle Abnahme tritt bei allen Lautstärken auf. Es ist zu beachten, dass die Betragszeichen, wie auch im Folgenden, dann zum Tragen kommen, wenn die Lautstärkepegel-Nulllinie in die Entzerrungskurve gelegt wird.

Gemäß einer weiteren vorteilhaften Weiterbildung (Anspruch 3) ist die Betragsdifferenz $|P(n)| - |P(n+1)|$ für alle n konstant.

Das bedeutet zum Beispiel, dass in einem Diagramm, in dem die Lautheit in Dezibel als Funktion der logarithmisch aufgetragenen Frequenz dargestellt ist (Entzerrungskurve), alle Punkte $(f(n), |P(n)|)$ auf einer Geraden liegen.

Gemäß einer weiteren vorteilhaften Weiterbildung (Anspruch 4) ist $|P(n)| > |P(n+1)|$ für alle n kleiner oder gleich 2 dB (Dezibel).

Der Wert von 2 dB gilt für relativ leise Tongemische mit relativ geringer Lautstärke bzw. Lautheit, wobei "relativ leise" etwa 70 dB bedeutet und 'relativ laut' etwa 80 dB betragen würde.

Gemäß einer weiteren vorteilhaften Weiterbildung (Anspruch 5) ist $|P(n)| - |P(n+1)| > |P(n +1)| - |P(n+2)|$ für alle n.

Die Differenz der Absolutbeträge der Lautheit wird somit mit zunehmender Frequenz kleiner, so dass in dem oben genannten Diagramm die Kurve, auf der die Punkte $(f(n), |P(n)|)$ liegen, keine Gerade ergibt.

Gemäß einer weiteren vorteilhaften Weiterbildung (Anspruch 6) wird ein Verhältnis $\left|\dfrac{P(n)}{P(n+1)}\right|$ für ein gegebenes n mit zunehmender Lautheit des Tongemischs größer.

Das Verhältnis $\left|\dfrac{P(n)}{P(n+1)}\right|$ ist normalerweise frequenzabhängig, so dass sich das Verhältnis auf ein vorgegebenes n beziehen muss.

Gemäß einer weiteren vorteilhaften Weiterbildung (Anspruch 7) ist $f_0 = 1,2$ kHz.

Alternativ kann man auch vom Kammerton ausgehen, d. h. fo = 440 Hz.

Gemäß einer weiteren vorteilhaften Weiterbildung (Anspruch 8) ist für jedes Frequenzintervall

$$f_{(n)}^N \le f \le f_{(n+1)}^N \quad \text{entweder} \quad \frac{d^2}{df^2}P(f) < 0 \quad \text{oder}$$

$$\frac{d^2}{df^2}P(f) > 0.$$

Dadurch soll die 'Sinusartigkeit' (oder ‚Wellenartigkeit') der Entzerrungskurve zum Ausdruck gebracht werden. Das heißt, die Entzerrungskurve ähnelt einer Sinuskurve, ist jedoch nicht periodisch. Der erste Ausdruck $\frac{d^2}{df^2}P(f) < 0$ bezieht sich auf untere 'Halbwellen' oder Wellentäler (mit Minima), während sich der zweite Ausdruck $\frac{d^2}{df^2}P(f) > 0$ auf obere 'Halbwellen' oder Wellenberge (mit Maxima) bezieht. Aus Anspruch 8 folgt ferner, dass die Entzerrungskurve, ebenso wie eine Sinuskurve, stetig und differenzierbar ist.

Es ist zu beachten, dass die Wellenartigkeit der Entzerrungskurve die spektrale (d. h. frequenzabhängige) Empfindlichkeit des menschlichen Gehörs widerspiegelt, und zwar im doppelten Sinne. Zum einen im Sinne von "wiedergeben" und zum anderen im Sinne von "spiegeln", d. h. die Entzerrungskurve ist eine Spiegelung der Empfindlichkeitskurve des menschlichen Gehörs an ihrer Nulllinie.

Gemäß einer weiteren vorteilhaften Weiterbildung (Anspruch 9) ist die frequenzabhängige Änderung von Schallpegeln eine frequenzabhängige Absenkung und/oder Anhebung der Schallpegel.

Eine Absenkung von Schallpegeln hat gegenüber einer Anhebung von Schallpegeln den Vorteil, dass dadurch Phasenverschiebungen vermieden werden. Im praktischen Fall, in dem die Entzerrungskurve mit einer endlichen Anzahl von Reglern erzeug wird, werden bei einer Absenkung alle Regler aus ihrer jeweiligen Neutralstellung in die gleiche Richtung verschoben.

Gemäß der vorliegenden Erfindung (Anspruch 10) umfasst eine Audioanlage mit einem Eingang, einem Ausgang und einem mit dem Ausgang verbundenen Schallwandler einen Entzerrer nach einem der Ansprüche 1 bis 8, der in einer Wiedergabekette der Audioanlage dem Schallwandler vorgeschaltet ist.

Das heißt, der erfindungsgemäße Entzerrer wird auf das gesamte, von der Audioanlage ausgegebene Signal angewendet und entzerrt damit das 'verzerrte', normalerweise an die Audioanlage gegebene Signal.

Gemäß der vorliegenden Erfindung (Anspruch 11) ist zur gehörlinearisierenden Entzerrung eines Tongemischs aus Tönen unterschiedlicher Frequenzen (f) die Stärke der Entzerrung durch eine Entzerrungskurve (P(f)) festgelegt, die eine frequenzabhängige Änderung von Schallpegeln (P) der Töne zeigt und bei Frequenzen

$f_{(n)}^E = k^n \cdot f_0$ Extrema $(P(n) \equiv P(f_{(n)}))$ und bei Frequenzen $f_{(n)}^N = k^{(n-1/2)} \cdot f_0$ Nullpunkte $(N(n) \equiv N(f_{(n)}))$ besitzt, mit $n \in$ , $f_0$ einer Frequenz eines vorbestimmten Extremums $(P(0))$ und $1,5^2 \leq k \leq 1,8^2$.

Gemäß einer vorteilhaften Weiterbildung (Anspruch 12) besitzt die Entzerrungskurve (P(f)) die Form einer gedämpften Schwingung, die mit zunehmender Frequenz des Tongemischs abklingt.

Gemäß einer weiteren vorteilhaften Weiterbildung (Anspruch 13) wird ein Verhältnis $\left|\frac{P(n)}{P(n+1)}\right|$ mit zunehmender Lautheit des Tongemischs größer.

Weitere Vorteile und Merkmale der vorliegenden Erfindung werden ersichtlich aus der nachfolgenden Beschreibung mit Bezug auf die Figuren, in denen beispielhafte Entzerrungskurven erläutert sind. In den Figuren sind:

Fig. 1A und 1B eine Darstellung einer Entzerrungskurve für einen rechten und einen linken Kanal gemäß einer ersten Ausführungsform;

Fig. 2A und 2B eine vergleichende Darstellung einer Entzerrungskurve gemäß Fig. 1 (unten) mit einer Entzerrungskurve gemäß einer zweiten Ausführungsform (oben), und

Fig. 3A und 3B eine vergleichende Darstellung einer Entzerrungskurve gemäß Fig. 1 (unten) mit einer Hörempfindlichkeitskurve (oben)

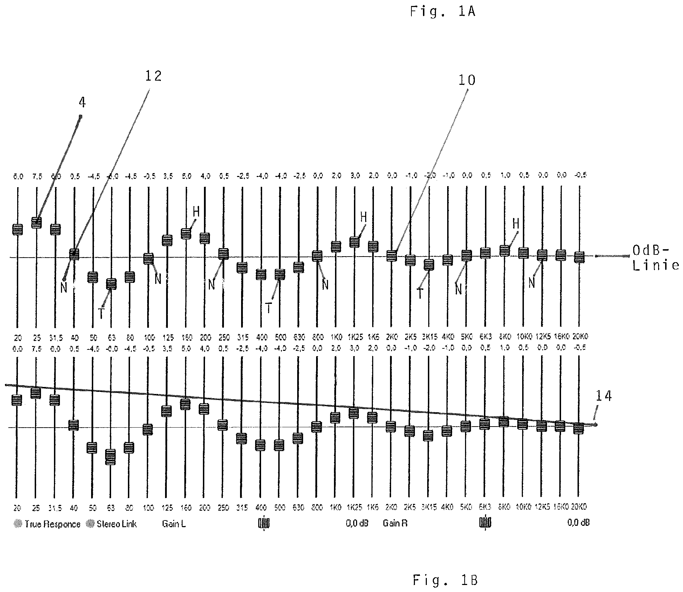

Die Fig. 1A und 1B sind Darstellungen von Entzerrungskurven 10 für einen rechten (oben) und einen linken (unten) Kanal gemäß einer ersten Ausführungsform (nur Fig. 1A ist mit Bezugszeichen versehen, Fig. 1B ist entsprechend).

Die Fig. 1A und 1B zeigen die frequenzabhängige Korrektur-Absenkung oder Anhebung gegenüber einer ‚Nulllinie N' - des Schallpegels (Lautheit), wobei die Frequenz jeweils am unteren Rand und logarithmisch und die Korrektur in Dezibel jeweils am oberen Rand aufgetragen ist. Die Korrekturen sind durch die Position von Reglern 12 dargestellt. Befindet sich ein Regler auf der Null-dB-Linie, so bleibt die zugehörige Frequenz unverändert. Deutlich zu erkennen ist die von den bekannten Entzerrungskurven 10 abweichende wellenförmige, zu höheren Frequenzen hin abklingende Struktur.

Wie es in den Fig. 1A und 1B gezeigt ist, befinden sich Anhebungsmaxima (Hochpunkte H der Entzerrungskurve 10) bei den Frequenzen 25 Hz, 160 Hz, 1250 Hz und 8000 Hz, während sich Absenkungsmaxima (Tiefpunkte T der Entzerrungskurve 10) bei 63 Hz, 400 / 500 Hz und 3150 Hz befinden. Somit befinden sich Extrema bei 25 Hz, 63 Hz, 160 Hz, 400 Hz, 1250 Hz, 3150 Hz und 8000 Hz. Die betragsmäßige Dämpfung dieser Frequenzen für eine gegebene Lautstärke beträgt: 7,5 dB, 5 dB, 5 dB, 4 dB, 3 dB, 2 dB und 1 dB.

Die Fig. 1A und 1B zeigen Entzerrungskurven 10, die mit einem im Handel erhältlichen Entzerrer erzeugt wurden. Musik unterschiedlicher Stilrichtungen, die mit einer solchen Entzerrungskurve 10 entzerrt wurde, wurde in zahlreichen Hörtests als "am natürlichsten" wahrgenommen. Es ist zu beachten, dass eine Multiplikation der Frequenz von 25 Hz des ersten Extremums mit dem Faktor k = 1,618$^2$ ziemlich genau die Frequenz des zweiten Extremums liefert: 25 Hz x 1,618$^2$ = 65,5 Hz. Ebenso liefert eine Multiplikation der Frequenz von 63 Hz des zweiten Extremums sehr genau die Frequenz des dritten Extremums: 63 Hz x 1,618$^2$ = 165 Hz, etc.

Es ist anzunehmen, dass ein Entzerrer, der eine noch genauere Einstellung erlaubt, zu dem Ergebnis führt, dass sich die Frequenzen der Extrema der Entzerrungskurve 10 durch Multiplikation mit 1,618$^2$ exakt ergeben, so dass in einer optimalen Entzerrungskurve 10 die empirisch gefundene Gesetzmäßigkeit des Goldenen Schnitts reflektiert ist.

Es ist zu beachten, dass die Hochpunkte H und die an der Null-dB-Linie nach oben gespiegelten Tiefpunkte T auf einer Geraden 14 liegen (der Übersichtlichkeit halber in Fig. 1B eingezeichnet). Ferner liegen die den Hochpunkten H (Tiefpunkten T) benachbarten Amplituden vorzugsweise um maximal 1,5 dB unter (über) dem Wert des Hochpunkts H (Tiefpunkts T), wobei "benachbart" sich auf die benachbarten Regler des oben genannten Equalizers (Entzerrers) beziehen.

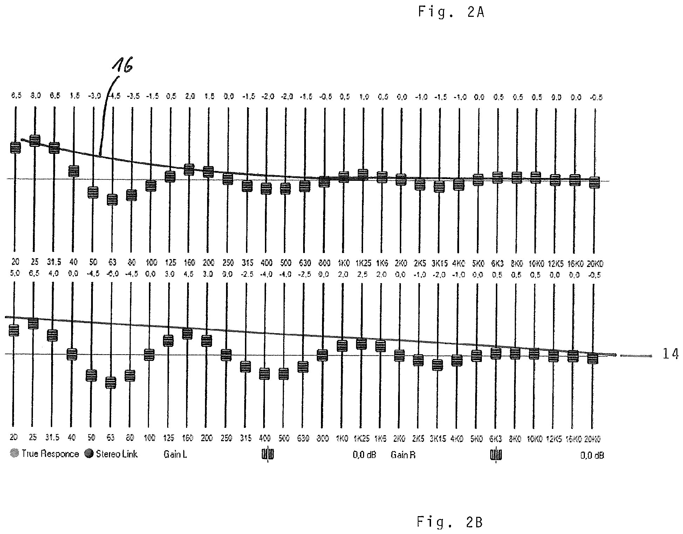

Die Fign. 2A und 2B sind eine vergleichende Darstellung einer Entzerrungskurve 10 gemäß Fig. 1 (unten) mit einer Entzerrungskurve 10 gemäß einer zweiten Ausführungsform (oben).

Wie es in Fig. 2A gezeigt ist, liegen in der zweiten Ausführungsform, bei gleicher Darstellung (logarithmischer Auftragung der Frequenzen), die Extrema zwar bei gleichen Frequenzen wie in der ersten Ausführungsform, nicht jedoch auf einer Geraden. Das heißt die dB-Korrektur bei den jeweiligen Frequenzen ist anders. Eine Korrektur durch diese Entzerrungskurve 10 liefert eine weitere Verbesserung der natürlichen Wahrnehmung gegenüber einer Korrektur mit der Entzerrungskurve 10 gemäß der ersten Ausführungsform.

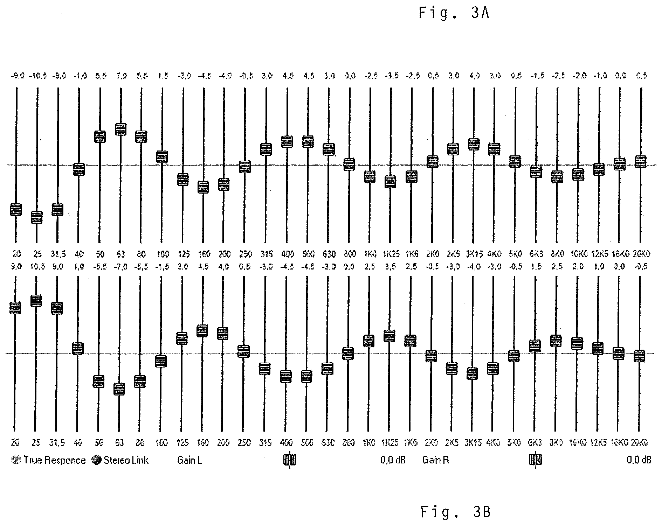

Fign. 3A und 3B zeigen eine vergleichende Darstellung einer Entzerrungskurve 10 gemäß Fig. 1 (unten) mit einer Hörempfindlichkeitskurve (oben).

Wie es oben bereits erwähnt ist, sind beide Kurven zueinander spiegelbildlich, so dass die "natürlichen Schwächen" des menschlichen Gehörs kompensiert werden.

### Patentansprüche

**1.** Entzerrer zur gehörlinearisierenden Entzerrung eines Tongemischs aus Tönen unterschiedlicher Frequenzen (f) gemäß einer Entzerrungskurve (P(f)), die eine frequenzabhängige Änderung von Schallpegeln (P) der Töne zeigt und bei Frequenzen $f_{(n)}^E = k^n \cdot f_0$ Extrema ($P(n) \equiv P(f_{(n)})$) und bei Frequenzen $f_{(n)}^N = k^{(n-1/2)} \cdot f_0$ Nullpunkte ($N(n) \equiv N(f_{(n)})$) besitzt, mit $n \in \mathbb{N}$, fo einer Frequenz eines vorbestimmten Extremums (P(0)) und $1,5^2 \leq k \leq 1,8^2$.

**2.** Entzerrer nach Anspruch 1, **dadurch gekennzeichnet, dass** $|P(n)| > |P(n+1)|$ $\forall n$.

**3.** Entzerrer nach Anspruch 2, **dadurch gekennzeichnet, dass** $|P(n)| - |P(n+1)|$ = konstant $\forall n$.

**4.** Entzerrer nach Anspruch 3, **dadurch gekennzeichnet, dass** $|P(n)| - |P(n+1)| \leq 2$ dB $\forall n$.

**5.** Entzerrer nach Anspruch 2, **dadurch gekennzeichnet, dass** $|P(n)| - |P(n+1)| > |P(n+1)| - |P(n+2)|$ $\forall n$.

**6.** Entzerrer nach einem der Ansprüche 1 bis 3, **dadurch gekennzeichnet, dass** $\left| \dfrac{P(n)}{P(n+1)} \right|$ für ein gegebenes n mit zunehmender Lautheit des Tongemischs größer wird.

**7.** Entzerrer nach einem der Ansprüche 1 bis 6, **dadurch gekennzeichnet, dass** $f_0$ = 1,2 kHz ist.

**8.** Entzerrer nach einem der Ansprüche 1 bis 6, **dadurch gekennzeichnet, dass** für jedes Frequenzintervall $f_{(n)}^N \leq f \leq f_{(n+1)}^N$ entweder $\dfrac{d^2}{df^2}P(f) < 0$ oder $\dfrac{d^2}{df^2}P(f) > 0$ ist.

**9.** Entzerrer nach einem der Ansprüche 1 bis 8, **dadurch gekennzeichnet, dass** die frequenzabhängige Änderung von Schallpegeln (P) eine frequenzabhängige Absenkung und/oder Anhebung der Schallpegel (P) ist.

**10.** Audioanlage mit einem Eingang, einem Ausgang und einem mit dem Ausgang verbundenen Schallwandler, **dadurch gekennzeichnet, dass** sie einen Entzerrer nach einem der Ansprüche 1 bis 9 umfasst, der in einer Wiedergabekette der Audioanlage dem Schallwandler vorgeschaltet ist.

**11.** Verfahren zur gehörlinearisierenden Entzerrung eines Tongemischs aus Tönen unterschiedlicher Frequenzen (f), **dadurch gekennzeichnet, dass** die Stärke der Entzerrung durch eine Entzerrungskurve (P(f)) festgelegt ist, die eine frequenzabhängige Änderung von Schallpegeln (P) der Töne zeigt und bei Frequenzen $f_{(n)}^E = k^n \cdot f_0$ Extrema ($P(n) \equiv P(f_{(n)})$) und bei Frequenzen $f_{(n)}^N = k^{(n-1/2)} \cdot f_0$ Nullpunkte ($N(n) \equiv N(f_{(n)})$) besitzt, mit $n \in \mathbb{N}$, $f_0$ einer Frequenz eines vorbestimmten Extremums (P(0)) und

$$1,5^2 \leq k \leq 1,8^2.$$

**12.** Verfahren nach Anspruch 11, **dadurch gekennzeichnet, dass** die Entzerrungskurve (P(f)) die Form einer gedämpften Schwingung besitzt, die mit zunehmender Frequenz des Tongemischs abklingt.

**13.** Verfahren nach Anspruch 12, **dadurch gekennzeichnet, dass** Verhältnis $\left|\dfrac{P(n)}{P(n+1)}\right|$ für ein gegebenes n mit zunehmender Lautheit des Tongemischs größer wird.

**Claims**

**1.** An equaliser for the aurally linearilized equalisation of a sound mix of sounds of different frequencies (f) according to an equalisation curve (P(f)) which shows a frequency-dependent change in sound levels (P) of the sounds and at frequencies of $f_{(n)}^E = k^n \cdot f_0$ has extremes $(P(n) \equiv P(f(fn)))$ and at frequencies of $f_{(n)}^N = k^{(n-1/2)} \cdot f_0$ zero points $(N(n) \equiv N(f_{(n)}))$, with $n \in \mathbb{N}$, $f_0$ as a frequency of a predetermined extreme (P(0)) and $1,5^2 \leq k \leq 1,8^2$.

**2.** The equaliser according to claim 1, **characterised in that** $|P(n)| > |P(n+1)|$ $\forall n$.

**3.** The equaliser according to claim 2, **characterised in that** $|P(n)| - |P(n+1)| =$ constant $\forall n$.

**4.** The equaliser according to claim 3, **characterised in that** $|P(n)| - |P(n+1)| \leq 2$ dB $\forall n$.

**5.** The equaliser according to claim 2, **characterised in that** $|P(n)| - |P(n+1)| > |P(n+1)| - |P(n+2)|$ $\forall n$.

**6.** The equaliser according to any one of claims 1 to 3, **characterised in that** $\left|\dfrac{P(n)}{P(n+1)}\right|$ becomes greater for a given value of n with increasing loudness of the sound mix.

**7.** The equaliser according to any one of claims 1 to 6, **characterised in that** $f_0 = 1,2$ kHz.

**8.** The equaliser according to any one of claims 1 to 6, **characterised in that** for each frequency interval

$f_{(n)}^N \leq f \leq f_{(n+1)}^N$, is either $\dfrac{d^2}{df^2}P(f) < 0$ or $\dfrac{d^2}{df^2}P(f) > 0$.

**9.** The equaliser according to any one of claims 1 to 8, **characterised in that** the frequency-dependent change in sound levels (P) is a frequency-dependent decrease and/or increase of the sound levels (P).

**10.** An audio system with an input, an output and a sound transducer connected to the output, **characterised in that** it comprises an equaliser according to any one of claims 1 to 9 which in a reproduction chain of the audio system is arranged upstream of the sound transducer.

**11.** A method of aurally linearized equalisation of a sound mix of sounds of different frequencies (f), **characterised in that** the extent of equalisation is determined by an equalisation curve (P(f)) which shows a frequency-dependent change in sound levels (P) of the sounds and at frequencies of $f_{(n)}^E = k^n \cdot f_0$ has extremes $(P(n) \equiv P(f_{(n)}))$ and at frequencies of $f_{(n)}^N = k^{(n-1/2)} \cdot f_0$ zero points $(N(n) = N(f_{(n)}))$, with $n \in \mathbb{N}$, $f_0$ as a frequency of a predetermined extreme (P(0)) and $1,5^2 \leq k \leq 1,8^2$.

**12.** The method according to claim 11, **characterised in that** the equalisation curve (P(f) has the shape of damped oscillation which attenuates with increasing frequency of the sound mix.

**13.** The method according to claim 12, **characterised in that** the ratio $\left|\dfrac{P(n)}{P(n+1)}\right|$ for a given value of n becomes greater with increasing loudness of the sound mix.

**Revendications**

**1.** Égaliseur pour l'égalisation de la linéarisation à l'ouïe d'un mélange de sons provenant de différentes fréquences (f) selon une courbe d'égalisation (P(f)) qui montre un changement en fonction de la fréquence des niveaux sonores (P) des sons et qui possède dans des fréquences $f_{(n)}^E = k^n \cdot f_0$ des valeurs extrêmes $(P(n) \equiv P(f_{(n)}))$ et dans des fréquences

$$f_{(n)}^{N} = k^{(n-1/2)} \cdot f_0 \text{ des points zéro } (N(n) \equiv N(f_{(n)})),$$

avec $n \in \mathbb{N}$ , $f_0$ d'une fréquence d'une valeur extrême prédéfinie (P(0)) et $1{,}5^2 \leq k \leq 1{,}8^2$.

**2.** Égaliseur selon la revendication 1, **caractérisé en ce que** $|P(n)| > |P(n+1)| \; \forall n$.

**3.** Égaliseur selon la revendication 2, **caractérisé en ce que** $|P(n)| - |P(n+1)| = \text{constant} \; \forall n$.

**4.** Égaliseur selon la revendication 3, **caractérisé en ce que** $|P(n)| - |P(n+1)| \leq 2 \text{ dB} \; \forall n$.

**5.** Égaliseur selon la revendication 2, **caractérisé en ce que** $|P(n)| - |P(n+1)| > |P(n+1)| - |P(n+2)| \; \forall n$.

**6.** Égaliseur selon l'une des revendications 1 à 3, **caractérisé en ce que** $\left| \dfrac{P(n)}{P(n+1)} \right|$ pour un n donné devient plus grand avec l'augmentation de l'intensité du volume sonore (sonie) du mélange de son.

**7.** Égaliseur selon l'une des revendications 1 à 6, **caractérisé en ce que** $f_0$ est = 1,2 kHz.

**8.** Égaliseur selon l'une des revendications 1 à 6, **caractérisé en ce que**, pour chaque intervalle de fréquence $f_{(n)}^{N} \leq f \leq f_{(n+1)}^{N}$, soit $\dfrac{d^2}{df^2} P(f)$ est < 0, soit $\dfrac{d^2}{df^2} P(f)$ est > 0.

**9.** Égaliseur selon l'une des revendications 1 à 8, **caractérisé en ce que** la variation des niveaux sonores (P) en fonction de la fréquence équivaut à une réduction et/ou une augmentation des niveaux sonores (P) en fonction de la fréquence.

**10.** Système audio comprenant une entrée, une sortie et un convertisseur de son connecté à la sortie, **caractérisé en ce qu'**il comprend un égaliseur selon l'une des revendications 1 à 9, qui est connecté en amont du convertisseur de son dans une chaîne de reproduction du système audio.

**11.** Procédé pour l'égalisation de la linéarisation à l'ouïe d'un mélange de sons provenant de différentes fréquences (f), **caractérisé en ce que** la force de l'égalisation est déterminée par une courbe d'égalisation (P(f)) qui montre une variation des niveaux sonores (P) des sons dépendante de la fréquence et qui possède dans des fréquences $f_{(n)}^{E} = k^{n} \cdot f_0$ des valeurs extrêmes (P(n) ≡ P(f_{(n)})) et dans des fréquences $f_{(n)}^{N} = k^{(n-1/2)} \cdot f_0$ des points zéro (N(n) ≡ N(f_{(n)})), avec $n \in \mathbb{N}$, $f_0$ d'une fréquence d'une valeur extrême prédéfinie (P(0)) et $1{,}5^2 \leq k \leq 1{,}8^2$.

**12.** Procédé selon la revendication 11, **caractérisé en ce que** la courbe d'égalisation (P(f)) a la forme d'une vibration amortie qui s'atténue avec la fréquence croissante du mélange sonore.

**13.** Procédé selon la revendication 12, **caractérisé en ce que** le rapport $\left| \dfrac{P(n)}{P(n+1)} \right|$ pour un n donné devient plus grand avec l'augmentation de l'intensité du volume sonore (sonie) du mélange de son.

Fig. 1A

Fig. 1B

Fig. 2A

Fig. 2B

Fig. 3A

| 20 | 25 | 31,5 | 40 | 50 | 63 | 80 | 100 | 125 | 160 | 200 | 250 | 315 | 400 | 500 | 630 | 800 | 1K0 | 1K25 | 1K6 | 2K0 | 2K5 | 3K15 | 4K0 | 5K0 | 6K3 | 8K0 | 10K0 | 12K5 | 16K0 | 20K0 |

True Responce    Stereo Link        Gain L                                    0,0 dB    Gain R                                    0,0 dB

Fig. 3B